# EUROPEAN PATENT APPLICATION

(11) **EP 3 102 010 A1**
(43) Date of publication of application: **07.12.2016**
(21) Application number: 15170230.5
(22) Date of filing: 02.06.2015
(51) Int. Cl.: H05K 1/00, H05K 1/03

(54) **POWER DELIVERY NETWORK FOR A PLURALITY OF TRANSCEIVERS IMPLEMENTED ON AN INTEGRATED CIRCUIT**

(71) Applicant: Tyco Electronics Svenska Holdings AB, 175 26 Jaerfaella (SE)
(72) Inventor: Kaikkonen, Andrei, 17548 Jaerfaella (SE); Svenson, Lars-Goete, 19133 Sollentuna (SE); Lundqvist, Lennart Per Olof, 17560 Jaerfaella (SE); Chacinski, Marek Grzegorz, 12358 Farsta (SE); Chitica, Nicolae Pantazi, 16471 Kista (SE)
(74) Representative: Grünecker Patent- und Rechtsanwälte PartG mbB

(57) **Abstract**

The present invention relates to a power delivery network for providing electric current from a power supply to a radio frequency device mounted on a printed circuit board. The power delivery network comprises: the printed circuit board; the power supply; a radio frequency device adapted to draw an electric current from the power supply, varying in time, with frequencies in a predetermined frequency range; a connection line for providing the electric current from the power supply to the radio frequency device, wherein the connection line is connected to the power supply at one end thereof and to the radio frequency device at an other end thereof, and the connection line shows a parasitic impedance in the predetermined frequency range; a first capacitor coupled between the one end of the connection line and ground of the printed circuit board; a second capacitor coupled between the other end of the connection line and ground of the printed circuit board, wherein the connection line and the first capacitor form the first branch of a parallel circuit, the second capacitor forms the second branch of the parallel circuit, the first capacitor is configured such that in the predetermined frequency range, the resonance frequency of the parallel circuit is only determined by the parasitic inductance of the connection line and the capacitance of the second capacitor, and the second branch of the parallel circuit is configured to decrease the quality factor of the parallel circuit in such a way that the impedance seen by the radio frequency device towards the power supply is lower than a predetermined impedance in the predetermined frequency range.

## Description

The present invention relates to a power delivery network for providing electric current from a power supply to at least one radio frequency device mounted on a printed circuit board. In particular, the present invention relates to a power delivery network for providing electric current to a plurality of radio frequency devices mounted on a printed circuit board, which are adapted for data transmission rates of 25 Gbps.

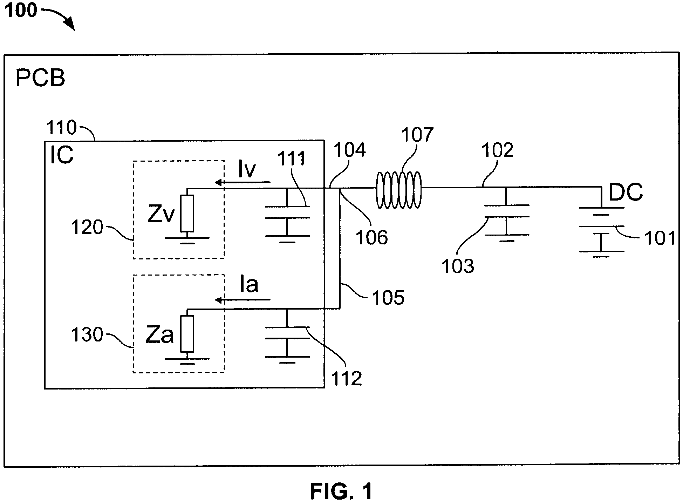

The goal of the power delivery network is to provide clean power and reference voltage to the active radio frequency devices on the die/chip. In particular, radio frequency devices used in communication systems having data transmission rates of, for instance, 25 Gbps need clean power to meet their maximum operating frequency specifications. A schematic of a power delivery network used in a communication system for data transmission rates of 25 Gbps is shown in Fig. 1.

The power delivery network represented in Fig. 1 provides electric current from the power supply 101 to the transceivers 120 and 130, which are implemented on the integrated circuit 110. The integrated circuit 110 is mounted on the printed circuit board 100 and connected to the power supply 101 via the connection lines 104 and 105. The connection lines 104 and 105 are provided on the printed circuit board 100, wherein the connection line 104 extends from a terminal of the power supply 101 (not shown in Fig. 1) to a first terminal of the integrated circuit 110, to which the transceiver 120 is connected. The connection line 105 includes a part 102 of the connection line 104, which extends from the terminal of the power supply 101 to a branch point 106 at the connection line 104, wherefrom the connection line 105 branches off to a second terminal of the integrated circuit 110, to which the transceiver 130 is connected.

The transceiver 120 is adapted to draw the electric current Iv from the power supply 101, and the transceiver 130 is adapted to draw the electric current la from the power supply 101. The electric currents Iv and la are varying in time, having frequencies in a frequency range around 200 MHz. At these frequencies, the transceiver 120 has the (input) impedance Zv, and the transceiver 130 has the (input) impedance Za. Also, at these frequencies, the connection line 104 shows a first parasitic impedance, which is determined by the first parasitic inductance 107 of the connection line 104, and the connection line 105 shows a second parasitic impedance, which is determined by the second parasitic inductance of the connection line 105.

Furthermore, the power delivery network shown in Fig. 1 includes the decoupling capacitors 103, 111 and 112. The decoupling capacitor 103 is mounted on the printed circuit board 100 and coupled between the end of the connection line 104, which is connected to the power supply 101, and ground. The decoupling capacitor 111 is integrated on the integrated circuit 110 and coupled between the first terminal of the integrated circuit 110 and ground. Also, the capacitor 112 is integrated on the integrated circuit 110 and coupled between the second terminal of the integrated circuit 110 and ground. Typically, the capacitance of any of the decoupling capacitors 111 and 112 is 200 pF, while the capacitance of the decoupling capacitor 103 is larger, about 0.1 µF.

The connection line 104 and the capacitor 103 form the first branch of a first parallel circuit, and the capacitor 111 forms the second branch of the first parallel circuit. As the capacitance of the capacitor 103 is significantly higher than the capacitance of the capacitor 111, at frequencies around 200 MHz, the capacitor 103 acts as a short in the first branch of the first parallel circuit. Consequently, the quality factor (Q-factor) of the first parallel circuit is mainly/only determined by the parasitic inductance 107 of the connection line 104 and the capacitance of the capacitor 111.

Also, the connection line 105 and the capacitor 103 form the first branch of a second parallel circuit, and the capacitor 112 forms the second branch of the second parallel circuit. As the capacitance of the capacitor 103 is significantly higher than the capacitance of the capacitor 112, at frequencies around 200 MHz, the capacitor 103 acts as a short in the first branch of the second parallel circuit. Consequently, the quality factor of the second parallel circuit is mainly/only determined by the parasitic inductance of the connection line 105 and the capacitance of the capacitor 111.

The electric currents Iv and la drawn by the transceiver 120 and 130, respectively, are switching currents with frequencies around 200 MHz. Crosstalk between the transceivers 120 and 130 due to the switching currents Iv and la may lead to a degradation of power integrity, thereby increasing the bit error rate of the data transmission performed by the transceivers. In order to reduce crosstalk due to the switching currents, the power delivery network impedance has to be minimized over the frequency range around 200 MHz. The power delivery network impedance is the impedance looking from a transceiver side towards the power supply 101, for instance, looking from the transceiver 120 side towards the power supply 101.

Minimizing the power delivery network impedance in order to avoid crosstalk from the transceiver 130 (as aggressor) to the transceiver 120 (as victim) involves/requires decreasing the parasitic inductance 107 of the conductive line 104 below 0.5 nH. Because of physical limitations, such low values of the parasitic inductance 107 cannot be achieved only by an appropriate design of the connection line 104 on the printed circuit board 100. Only values higher or equal than 1.5 nH can be achieved for the parasitic inductance 107, when optimizing the design (particularly, of the geometrical dimensions) of the connection line 104 on the printed circuit board 100. A value of 1.5 nH for the parasitic inductance 107 involves an increase of the power delivery network impedance of approx. 200 Ohm around the frequency of 200 MHz, while the resistive losses in the first parallel circuit are about 0.1 Ohm. Also, a value of 1.5 nH for the parasitic inductance 107 involves a high Q-factor of the first parallel circuit around the frequency of 200 MHz. Due to the high Q-factor of the first parallel circuit around 200 MHz, parasitic parallel resonance occurs between the capacitor 111 and the parasitic inductance 107. This resonance leads to a current depletion around 200 MHz and a signal degradation of the victim channel when operating at 25 Gbps.

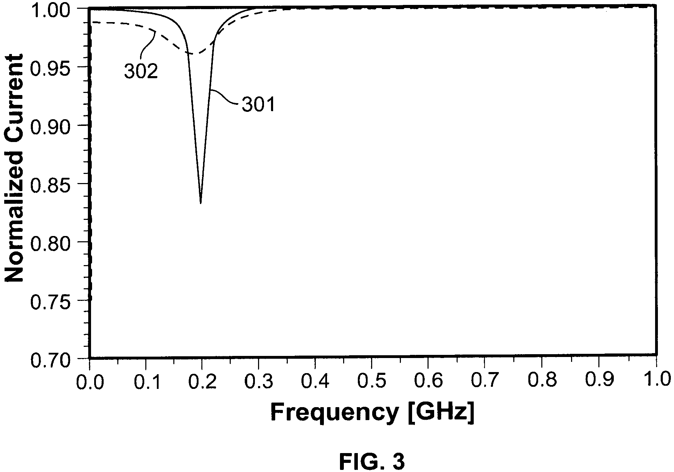

The curve 301 shown in Fig. 3 represents the normalized electric current Iv/Iv0 versus frequency. Iv0 is the electric current sourced by the victim, i.e. the transceiver 120, at frequencies that are far away from the resonance frequency of the first parallel circuit. The normalized current Iv/Iv0 shows a sharp peak at 200 MHz, corresponding to the current depletion caused by the resonance between the decoupling capacitor 111 and the parasitic inductance 107 of the first parallel circuit.

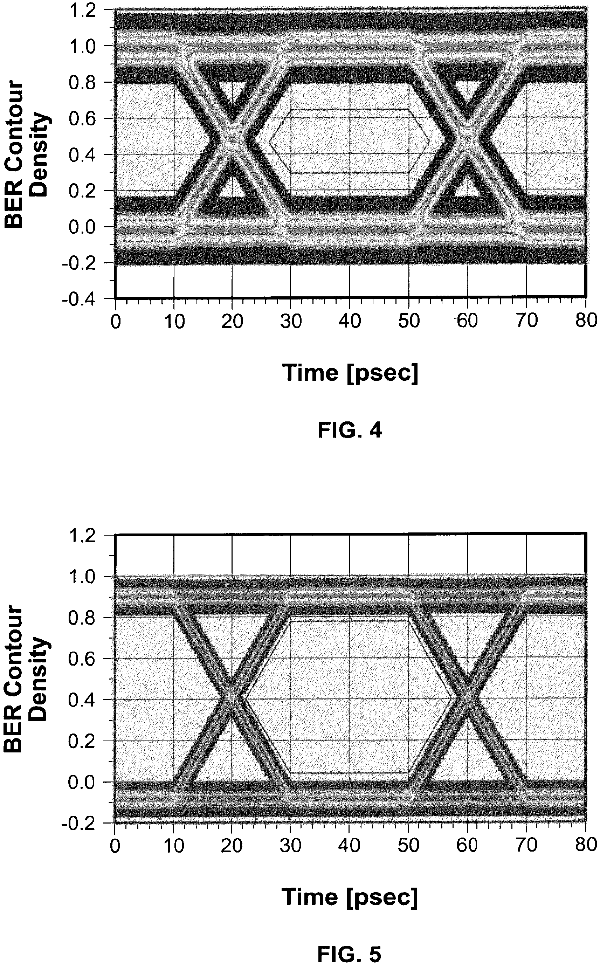

Fig. 4 illustrates the eye diagram of the electric current Iv sourced into the victim, i.e. the transceiver 120, when the transceivers 120 and 130, shown in Fig. 1, are operating at 25 Gbps. The eye height corresponding to a bit error rate of 10⁻¹² is 35%. It indicates a significant degradation of the signal in the victim channel.

### SUMMARY OF INVENTION

It is therefore an objective of the present invention to provide for a power delivery network, which supplies a plurality of radio frequency devices mounted on a printed circuit board with electric current, and which avoids/reduces crosstalk between the radio frequency devices of the plurality of radio frequency devices, thereby improving the signal quality of the signals processed by the plurality of radio frequency devices mounted on the printed circuit board.

This objective is achieved by the features as set forth in claim 1. Further advantageous embodiments of the present invention are set forth in the dependent claims.

The present invention is based on the idea that crosstalk from a first radio frequency device into a second radio frequency device can be effectively reduced by reducing the Q-factor of the parasitic parallel resonance between the decoupling capacitor connected to the supply terminal of the second radio frequency device and the parasitic inductance of the connection line connecting the supply terminal of the second radio frequency device with the power supply.

The Q-factor can be reduced in an advantageous manner by connecting a resistor, preferably a lump resistor, between ground and the connection line connecting the second radio frequency device with the power supply, in series with the decoupling capacitor connected to the terminal of the power supply. This measure significantly reduces the power delivery network impedance and reduces the current depletion in the electric current supplied to the second radio frequency device, at the parasitic parallel resonance frequency.

### BRIEF DESCRIPTION OF DRAWINGS

Fig. 1 shows the schematic of a known power delivery network;
Fig. 2 shows the schematic of a power delivery network according to a first embodiment of the present invention;
Fig. 3 shows the current drawn by the first transceiver (victim) vs. frequency for the known power delivery network and the power delivery network according to the first embodiment of the present invention;
Fig. 4 shows the eye diagram of the current drawn by the first transceiver (victim) of the known power delivery network; and
Fig. 5 shows the eye diagram of the current drawn by the first transceiver (victim) of the power delivery network according to the first embodiment of the present invention;

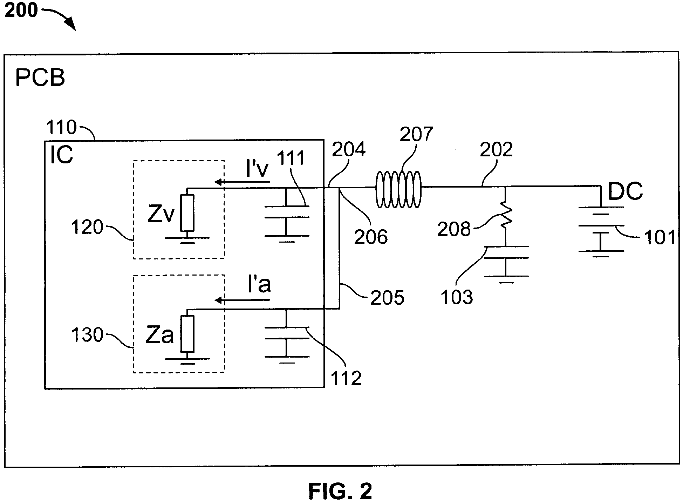

Referring now to Fig. 2, a first advantageous embodiment of a power delivery network, according to the present invention, is shown.

Fig. 2 shows a power delivery network for providing electric current from the power supply 101 to the transceivers 120 and 130, which are implemented on the integrated circuit 110 and adapted for data communication at a transmission rate of 25 Gbps. The integrated circuit 110 is mounted on the printed circuit board 200 and connected to the power supply 101 via the connection lines 204 and 205. The connection lines 204 and 205 are provided on the printed circuit board 200, wherein the connection line 204 extends from a terminal of the power supply 101 (not shown in Fig. 2) to a first supply terminal of the integrated circuit 110, to which the transceiver 120 is connected. The connection line 205 extends from the terminal of the power supply 101 to a second supply terminal of the integrated circuit 110, to which the transceiver 130 is connected, and includes a part 202 of the connection line 204, which extends from the terminal of the power supply 101 to a branch point 206 at the connection line 204, wherefrom the connection line 205 branches off to the second supply terminal of the integrated circuit 110.

The transceiver 120 is adapted to draw the electric current I'v from the power supply 101, and the transceiver 130 is adapted to draw the electric current I'a from the power supply 101. The electric currents I'v and I'a are varying in time, with frequencies in a predetermined frequency range. For instance, the predetermined frequency range is a frequency range around 200 MHz, when the transceivers 120 and 130 are adapted for transmissions rates of 25 Gbps. In the predetermined frequency range, the transceiver 120 has the impedance Zv, the transceiver 130 has the impedance Za, the connection line 204 shows a first parasitic impedance, which is mainly determined by the first parasitic inductance 207 of the connection line 204, and the connection line 205 shows a second parasitic impedance, which is determined by the second parasitic inductance of the connection line 205.

The power delivery network according to the first embodiment of the present invention further includes the decoupling capacitors 103, 111, 112, and the resistor 208. The decoupling capacitor 103 is mounted (directly) on the printed circuit board 100 and coupled between the end of the connection line 104, which is connected to the terminal of the power supply 101, and ground. The decoupling capacitor 111 is integrated on the integrated circuit 110 and coupled between the first supply terminal of the integrated circuit 110 and ground. Also, the capacitor 112 is integrated on the integrated circuit 110 and coupled between the second supply terminal of the integrated circuit 110 and ground. Typically, the capacitance of any of the decoupling capacitors 111 and 112 is 200 pF, while the capacitance of the decoupling capacitor 103 is significantly larger than the capacitance of any of the decoupling capacitors 111 and 112, about 0.1 µF. The resistor 208, preferably a lump resistor, is connected between ground of the printed circuit board 200 and the end of the connection line 204 which is connected to the terminal of the power supply 101, in series with the decoupling capacitor 103. Preferably, the resistor 208 has a resistance of 2 Ohm.

The connection line 204, the resistor 208 and the capacitor 103 form the first branch of a first parallel circuit; and the capacitor 111 forms the second branch of the first parallel circuit. As the capacitance of the capacitor 103 is significantly higher than the capacitance of the capacitor 111, at frequencies around 200 MHz, the capacitor 103 acts as a short in the first branch of the first parallel circuit. Consequently, the quality factor (Q-factor) of the first parallel circuit is mainly/only determined by the parasitic inductance 207 of the connection line 204, the resistance of the resistor 208, and the capacitance of the capacitor 111.

The connection line 205, the resistor 208 and the capacitor 103 form the first branch of a second parallel circuit; and the capacitor 112 forms the second branch of the second parallel circuit. As the capacitance of the capacitor 103 is significantly higher than the capacitance of the capacitor 112, at frequencies around 200 MHz, the capacitor 103 acts as a short in the first branch of the second parallel circuit. Consequently, the Q-factor of the second parallel circuit is mainly/only determined by the parasitic inductance of the connection line 205, the resistance of the resistor 208, and the capacitance of the capacitor 111.

In the first embodiment of the present invention, the first parallel circuit and/or the second parallel circuit show a parasitic parallel resonance at a frequency of 200 MHz. However, because of the resistor 208, the Q-factor of the first parallel circuit of the power delivery network according to the first embodiment of the present invention is lower than the Q-factor of the first parallel circuit of the power delivery network shown in Fig. 1, and the Q-factor of the second parallel circuit of the power delivery network according to the first embodiment of the present invention is lower than the Q-factor of the second parallel circuit of the power delivery network shown in Fig. 1.

As the Q-factor of the parasitic parallel resonance between the capacitor 111 and the parasitic inductance 207 in the power delivery network according to the first embodiment is reduced compared to the Q-factor of the parasitic parallel resonance between the capacitor 111 and the parasitic inductance 107 in the power delivery network shown in Fig. 1, the power delivery network impedance of the power delivery network according to the first embodiment, viewed from the transceiver 120 towards the power supply 101, is significantly reduced compared to the power delivery network impedance of the power delivery network shown in Fig. 1, viewed from the transceiver 120 towards the power supply 101.

Also, as the Q-factor of the second parallel circuit of the power delivery network according to the first embodiment is lower than the Q-factor of the second parallel circuit of the power delivery network shown in Fig. 1, the power delivery network impedance of the power delivery network according to the first embodiment, viewed from the transceiver 130 towards the power supply 101, is significantly reduced compared to the power delivery network impedance of the power delivery network shown in Fig. 1, viewed from the transceiver 130 towards the power supply 101.

The electric currents I'v and I'a drawn by the transceiver 120 and 130, respectively, are switching currents with frequencies around 200 MHz. Crosstalk between the transceivers 120 and 130 due to the switching currents I'v and I'a is reduced in the power delivery network according to the first embodiment compared to the power delivery network shown in Fig. 1, because the power delivery network impedance of the power delivery network according to the first embodiment, compared to the power delivery network impedance of the power delivery network shown in Fig. 1, is decreased by reducing the Q factor of the parasitic parallel resonances in the power delivery network. As the crosstalk between the transceivers 120 and 130 is reduced, also the current depletion around 200 MHz, caused by the parasitic parallel resonances in the power delivery network, is significantly reduced in the power delivery network according to the first embodiment.

The curve 302 shown in Fig. 3 represents the normalized electric current I'v/I'v0 versus frequency. I'v0 is the electric current sourced by the transceiver 120 (as a victim) at frequencies that are far away from the parasitic resonance frequency of the first parallel circuit. The normalized current I'v/I'v0 shows a peak/depletion at 200 MHz, which is more leveled than the peak/depletion of the normalized current Iv/Iv0, shown by the curve 301. Accordingly, the current depletion caused by the resonance between the decoupling capacitor 111 and the parasitic inductance 207 in the power delivery network according to the first embodiment is reduced compared to the current depletion caused by the resonance between the decoupling capacitor 111 and the parasitic inductance 107 in the power delivery network shown in Fig. 1.

Fig. 5 illustrates the eye diagram of the electric current I'v sourced into the victim, i.e. the transceiver 120, when the transceivers 120 and 130, shown in Fig. 2, are operating at 25 Gbps. The eye height corresponding to a bit error rate of 10⁻¹² is 80%. This is considerably higher than the eye height of the eye diagram shown in Fig. 4, which amounts only 35% at a bit error rate of 10⁻¹². Fig. 4 illustrates the eye diagram of the electric current Iv sourced into the (victim) transceiver 120 of the power delivery network shown in Fig. 1.

The power delivery network according to the first embodiment of the present invention has an improved power integrity compared to the power delivery network shown in Fig 1. Consequently, the signal quality of the signals provided by the transceivers 120 and 130 of the power delivery network according to the first embodiment is improved compared to the signal quality of the signals provided by the transceivers 120 and 130 of the power delivery network shown in Fig. 1.

In the first embodiment of the present invention, the reduction of the Q-factor of the parasitic parallel resonances in the power delivery network is due to the resistor 208, which is connected in series with the decoupling capacitor 103.

However, the present invention is not limited to this embodiment, but is also applicable to a second embodiment, wherein a connection line for providing an electric current from the power supply to a transceiver includes a transmission line, and the reduction of the Q-factor of the parasitic parallel resonances in the power delivery network is achieved by increasing the loss of the transmission line, instead of using the resistor 208 of the first embodiment. The loss of the transmission line can be increased by increasing its resistive loss and/or its dielectric loss.

The present invention is also applicable to a third embodiment, wherein a connection line for providing an electric current from the power supply to a transceiver includes a transmission line, and the reduction of the Q-factor of the parasitic parallel resonances in the power delivery network is achieved by increasing the loss of the transmission line in combination with a resistor connected in series with the decoupling capacitor connected to the terminal of the power supply.

The first embodiment of the present invention has an advantage over the second and third embodiments of the present invention in that it does not increase the DC voltage drop across the power delivery network.

The parasitic parallel resonances of the power delivery network are due to parallel circuits, each parallel circuit has a first branch including the decoupling capacitor connected to the supply terminal of a transceiver, and a second branch including the parasitic inductance of the connection line connecting the power supply with the supply terminal of the respective transceiver. In accordance with the present invention, the second branch of the parallel circuit is configured to decrease the quality factor of the parallel circuit in such a way that the impedance seen by the transceiver towards the power supply, at the resonance frequency of the parallel circuit, is lower than a predetermined impedance.

In the first, second and circuit embodiment of the present invention, the transceivers 120 and 130 are implemented on the integrated circuit 110, which is mounted on the printed circuit board 200. Also, the decoupling capacitors 111 and 112 are integrated in the integrated circuit 110. However, the present invention is not limited to these embodiments, but is also applicable to embodiments, wherein the transceivers and their respective decoupling capacitors are directly mounted on the printed circuit board.

Also, the present is invention is applicable to embodiments having transmitters, or receivers, or any other radio frequency devices instead of the transceivers 120 and 130.

### Reference Numerals

| **Reference Numeral** | **Description** |
|---|---|
| 100 | Printed circuit board |
| 101 | DC source |
| 102 | Common part of the first and second connection lines |
| 103 | Off-chip decoupling capacitor |
| 104 | First connection line |
| 105 | Second connection line |
| 106 | Branch point |
| 107 | Parasitic inductance of the first connection line |
| 110 | Integrated circuit (IC) |
| 111, 112 | On-chip decoupling capacitor |
| 120 | Transceiver (victim) |
| 130 | Transceiver (aggressor) |
| 200 | Printed circuit board |
| 202 | Common part of the first and second connection lines |
| 204 | First connection line |
| 205 | Second connection line |
| 206 | Branch point |
| 207 | Parasitic inductance of the first connection line |
| 208 | Resistor |
| 301, 302 | Normalized current of the victim transceiver vs. frequency |

## Claims

1. A power delivery network for providing electric current from a power supply to at least one radio frequency device mounted on a printed circuit board, comprising:
the printed circuit board (200);
the power supply (101);
a first radio frequency device (120) adapted to draw a first electric current from the power supply (101), varying in time, with frequencies in a predetermined frequency range;
a first connection line (204) for providing the first electric current from the power supply (101) to the first radio frequency device (120),
wherein the first connection line (204) is connected to the power supply (101) at one end thereof and to the first radio frequency device (120) at an other end thereof, and
the first connection line (204) shows a first parasitic impedance in the predetermined frequency range;
a first capacitor (103) coupled between the one end of the first connection line (204) and
ground of the printed circuit board (200);
a second capacitor (111) coupled between the other end of the first connection line (204) and ground of the printed circuit board (200),
wherein the first connection line (204) and the first capacitor (103) form the first branch of a first parallel circuit,
the second capacitor (111) forms the second branch of the first parallel circuit,
the first capacitor (103) is configured such that in the predetermined frequency range, the resonance frequency of the first parallel circuit is mainly/only determined by the parasitic inductance (207) of the first connection line (204) and the capacitance of the second capacitor (111), and
the second branch of the first parallel circuit is configured to decrease the quality factor of the first parallel circuit in such a way that the impedance seen by the first radio frequency device (120) towards the power supply (101) is lower than a predetermined impedance in the predetermined frequency range.

2. The power delivery network according to claim 1, wherein the decrease of the quality factor of the first parallel circuit is achieved by a resistor (208), preferably a lump resistor, connected between the one end of the first connection line (204) and ground, in series with the first capacitor (103).

3. The power delivery network according to claim 1, wherein the first connection line (204) includes a first transmission line,
wherein the decrease of the quality factor of the first parallel circuit is achieved by a first transmission line adapted to have a power loss not lower than a first predetermined power loss, and/or
a lump resistor (208) connected between the one end of the first connection line (204) and ground, in series with the first capacitor (103).

4. The power delivery network according to any of claims 1 to 4, wherein the first radio frequency device (120) is implemented in an integrated circuit (110) mounted on the printed circuit board (200), and
the second capacitor (111) and a part of the first connection line (204), extending from the other end of the first connection line (204), are integrated in the integrated circuit (110).

5. The power delivery network according to any of claims 1 to 4, further comprising:
a second radio frequency device (130) adapted to draw a second electric current from the power supply, varying in time, with frequencies in the predetermined frequency range;
a second connection line (205) for providing the second electric current from the power supply (101) to the second radio frequency device (130),
wherein the second connection line (205) includes a part (202) of the first connection line (204), which extends from the one end of the first connection line (204) to a branch point (206) at the first connection line (204), where the second connection line (205) branches off to the second radio frequency device (130),
the second connection line (205) is connected to the power supply (101) at one end thereof and to the second radio frequency device (130) at an other end thereof,
the second connection line (205) shows a second parasitic impedance in the predetermined frequency range, and
the first capacitor (103) is coupled between the one end of the second connection line (205) and ground of the printed circuit board (200);
a third capacitor (112) coupled between the other end of the second connection line (205) and ground of the printed circuit board (200),
wherein the second connection line (205) and the first capacitor (103) form the first branch of a second parallel circuit,
the third capacitor (112) forms the second branch of the second parallel circuit,
the first capacitor (103) is configured such that in the predetermined frequency range, the resonance frequency of the second parallel circuit is mainly/only determined by the parasitic inductance of the second connection line (205) and the capacitance of the third capacitor (112), and
the second branch of the second parallel circuit is configured to decrease the quality factor of the second parallel circuit in such a way that the impedance seen by the second radio frequency device (130) towards the power supply (101) is lower than a predetermined impedance in the predetermined frequency range.

6. The power delivery network according to claim 5, wherein the decrease of the quality factor of the second parallel circuit is achieved by the resistor (208) connected between the one end of the first connection line (204) and ground, in series with the first capacitor (103).

7. The power delivery network according to claim 5, wherein the second connection line (205) includes a second transmission line,
wherein the decrease of the quality factor of the second parallel circuit is achieved by a second transmission line adapted to have a power loss not lower than a second predetermined power loss, and/or
the resistor (208) connected between the one end of the first connection line (204) and ground, in series with the first capacitor (103).

8. The power delivery network according to any of claims 5 to 7, wherein the second radio frequency device (130) is implemented in the integrated circuit (110) mounted on the printed circuit board (200), and
the third capacitor (112) and a part of the second connection line (205), extending from the other end of the second connection line (205), are integrated in the integrated circuit (110).

9. The power delivery network according to any of claims 1 to 8, wherein the first radio frequency device (120) is any of a transceiver, a receiver and a transmitter, and/or
the second radio frequency device (130) is any of a transceiver, a receiver and a transmitter.

10. The power delivery network according to any of claims 1 to 9, wherein the first capacitor (103) and/or the second capacitor (111) and/or the third capacitor (112) are/is a decoupling capacitor.

11. The power delivery network according to any of claims 1 to 10, wherein the resonance frequency of the first parallel circuit and/or the resonance frequency of the second parallel circuit is 200 MHz.

12. The power delivery network according to any of claims 1 to 11, wherein the first radio frequency device (120) and/or the second radio frequency device (130) are/is adapted for data transmission rates of 25 Gbps.
